# Europäisches Patentamt
# European Patent Office
# Office européen des brevets

(19)

(11) Veröffentlichungsnummer: **0 098 326**
**B1**

(12) **EUROPÄISCHE PATENTSCHRIFT**

(45) Veröffentlichungstag der Patentschrift:
**18.12.85**

(51) Int. Cl.⁴: **G 08 B  29/00**, G 08 B  19/00

(21) Anmeldenummer: **82106181.9**

(22) Anmeldetag: **10.07.82**

(54) **Schaltungsanordnung für eine Gefahrenmeldeanlage.**

(43) Veröffentlichungstag der Anmeldung:
**18.01.84 Patentblatt 84/3**

(45) Bekanntmachung des Hinweises auf die Patenterteilung:
**18.12.85 Patentblatt 85/51**

(84) Benannte Vertragsstaaten:
**CH DE FR IT LI NL**

(56) Entgegenhaltungen:
**EP - A - 0 026 461**
**DE - A - 2 632 738**
**FR - E - 94 224**

**SIEMENS ZEITSCHRIFT, Band 48, Nr. 3, 1974, Seiten 170-172, Erlangen, DE., J. KÖTTER et al.: "Leistungsverstärker im Bausteinsystem SIMADYN C"**

(73) Patentinhaber: **Fritz Fuss Kom.-Ges.,**
**Johannes-Mauthe-Strasse 14, D-7470 Albstadt 1 (DE)**

(72) Erfinder: **Künzel, Reiner, Roschbachstrasse 35,**
**D-7460 Balingen-Zillhausen (DE)**

(74) Vertreter: **Weber, Otto Ernst, Dipl.-Phys.,**
**Hofbrunnstrasse 36, D-8000 München 71 (DE)**

## Beschreibung

Die Erfindung betrifft eine Schaltungsanordnung für eine Gefahrenmeldeanlage, insbesondere für eine Einbruch- oder Brandmeldeanlage, mit wenigstens einem in einer ruhestrommässig überwachten Meldelinie angeordneten Alarm-Fühler, der beim Ansprechen im Alarm-Fall seinen Widerstand wesentlich verändert, wobei der Alarm-Fühler in Reihe mit einem Messwiderstandsglied einen Zweig einer Brückenschaltung bildet, deren anderer Zweig aus einer vorgebbaren Anzahl von Spannungsteiler-Widerständen gebildet ist, und wobei an die Brückenanordnung ein Spannungskomparator angeschlossen ist, dessen Ausgang mit einer Steuerstufe verbunden ist, in welcher eine Auswertung eines die Bückenanordnung verstimmenden Alarmsignals nach vorgebbaren Kriterien erfolgt.

Eine solche Schaltungsanordnung für eine Gefahrenmeldeanlage ist allgemein bekannt, vgl. beispielsweise die FR-E Nr. 94224, bei der zusätzlich, um den Meldestrom gering zu halten, die Brückenspannung über einen Operationsverstärker abgegriffen wird, bevor sie an die Steuerstufe zur Auswertung gelegt ist.

Bei Gefahrenmeldeanlagen wie Einbruchmeldeanlagen oder Brandmeldeanlagen werden die Alarm-Fühler, die auf diesem Fachgebiet auch als Melder oder Sensoren bezeichnet werden, zur Erfassung und Auswertung der jeweiligen physikalischen Grössen wie Rauch, Feuer oder arttypische menschliche Bewegungen, Glasbruch oder dergleichen an sogenannte Meldelinien angeschlossen. Diese Meldelinien bestehen im allgemeinen aus einer zweiadrigen Leitung, die ruhestrommässig überwacht wird, so dass neben der Aktivierung eines Fühlers oder Melders auch eine Auswertung sowie eine Lokalisierung eines Leitungsbruches, eines Leitungsschlusses oder auch von Manipulationen erkannt werden kann. Auf diese Weise lässt sich eine Gefahrenmeldeanlage gegen Sabotage absichern.

Bekannte Schaltungsanordnungen bestehen im wesentlichen aus einer Widerstands-Brücke, wobei der eine Brückenzweig aus einem strombegrenzenden Messwiderstand und einem oder mehreren Messfühlern gebildet wird. Um einen definierten Widerstand für die Messfühler zu erreichen, wird im allgemeinen parallel zu den Messfühlern ein sogenannter Meldelinien-Abschlusswiderstand verwendet. Der andere Brückenzweig wird aus Spannungsteiler-Widerständen gebildet, an denen jeweils Bezugswerte für verschiedene Kriterien wie Leitungsbruch, Alarm, Melderstörung und Leitungsschluss abgeleitet werden können.

In einem nachgeschalteten, mehrstufigen Spannungskomparator wird ein durch den Meldelinienstrom erzeugter Spannungsabfall am Messwiderstand mit jeweils vorgegebenen Bezugswerten verglichen.

Im Ruhezustand, wenn also die Meldelinien in Ordnung sind und keine Melderstörung vorliegt, wenn auch kein Alarm erzeugt wird, entsteht durch den normalen Meldelinienstrom ein Spannungsabfall, dessen Wert gerade so gross ist, dass er zwischen vorgebbaren Spannungswerten für die oben angeführten Kriterien wie Leitungsbruch oder Alarm liegt. Damit entsteht kein Ausgangssignal für eine Steuerelektronik, die dem Spannungskomparator nachgeschaltet ist.

Wenn nur einer der Melder durch eine überwachte physikalische Grösse aktiviert wird, so erzeugt dieser Melder eine Stromerhöhung, beispielsweise durch Zuschalten eines Widerstandes mit entsprechender Wichtung auf der Meldelinie. Die Stromerhöhung erzeugt am Messwiderstand einen erhöhten Spannungsabfall, und das Spannungspotential am entsprechenden Abgriff des Spannungsteilers sinkt unter die vorgegebene Bezugsspannung, so dass der Spannungskomparator aktiviert wird und an die nachgeschaltete Auswertestufe ein Alarm signalisiert wird.

In entsprechender Weise können auch andere Kriterien wie Melderstörung oder Leitungsstörung erfasst und ausgewertet werden. Damit eine Identifikation möglich ist, ob ein Alarm oder eine Melderstörung vorliegt, hat der jeweils zugeschaltete Widerstandswert eine spezielle Wichtung, die von der Auswertestufe erkannt werden kann.

Ein empfindlicher Nachteil der oben erläuterten bekannten Anordnung besteht darin, dass die Meldelinienspannung nicht konstant ist, sondern vom jeweiligen augenblicklichen Stromfluss abhängt. Wenn beispielsweise von einem Melder eine Störung signalisiert wird, so ist die Meldelinienspannung kleiner als im Ruhezustand.

Da die Betriebs- und Versorgungsspannung für die Auswerteelektronik über eine zweiadrige Meldelinienleitung zugeführt wird, ändert sich deren Spannungswert. Dabei verändern die gegenwärtig in der Praxis verwendeten Fühler oder Melder, beispielsweise Ionisations-Rauchmelder, ihre Ansprechempfindlichkeit. Die Folge davon können eine Fehlauslösung oder auch eine Nichtauslösung sein. Eine separate Spannungsstabilisierung, deren Wert unter der minimal zur Verfügung gestellten Meldelinienspannung liegen müsste, ist deshalb praktisch nicht verwendbar, da einerseits die Kosten pro Fühler oder Melder zu gross würden und andererseits der vom Fühler oder Melder aufgenommene Ruhestrom dadurch zu stark vergrössert würde. Ausserdem werden Ionisations-Rauchmelder mit abnehmenden Spannungswerten immer unempfindlicher.

Der Erfindung liegt die Aufgabe zugrunde, eine Schaltungsanordnung für eine Gefahrenmeldeanlage der eingangs näher genannten Art zu schaffen, mit welcher der Meldelinien-Strom praktisch verlustlos erfasst und ausgewertet werden kann, d. h., ohne zusätzlichen Spannungsabfall an einem Vorwiderstand.

Zur Lösung dieser Aufgabe sieht die Erfindung vor, dass das Messwiderstandsglied aus einem gegengekoppelten Operationsverstärker gebildet ist und dass die Gegenkopplung derart dimensioniert ist, dass das Potential des invertierenden Eingangs des Operationsverstärkers praktisch dem Potential des nicht invertierenden Eingangs entspricht, so dass die Meldespannung unabhängig vom fliessenden Meldestrom konstant bleibt.

Dabei ist vorzugsweise die Anordnung derart getroffen, dass dem Operationsverstärker eine Leistungsstufe nachgeschaltet ist.

Eine bevorzugte Ausführungsform sieht weiterhin vor, dass die Leistungsstufe im Gegenkopplungskreis angeordnet ist

Eine besonders vorteilhafte Weiterbildung der erfindungsgemässen Schaltungsanordnung zeichnet sich dadurch aus, dass die Leistungsstufe einen Transistor aufweist, dessen Basis über einen Vorwiderstand mit dem Ausgang des Operationsverstärkers verbunden ist, dessen Emitter mit dem Gegenkopplungswiderstand verbunden ist und dessen Kollektor über einen Widerstand mit der Versorgungsspannungsquelle verbunden ist.

Gemäss der Erfindung ist der wesentliche Vorteil erreichbar, dass eine besonders einfache und betriebssichere Messung des Meldelinien-Stromes ermöglicht wird, und zwar unter permanenter Beibehaltung der eingestellten Meldespannung.

Die erfindungsgemässe Schaltung bietet den erheblichen Vorteil, einen Strom ohne zusätzlichen Spannungsverlust zu messen.

Die Erfindung wird nachfolgend beispielsweise anhand der Zeichnung beschrieben; in dieser zeigen:

Fig. 1 ein Schaltschema einer erfindungsgemässen Schaltungsanordnung, und

Fig. 2 ein Prinzip-Schaltbild einer bevorzugten Ausführungsform der erfindungsgemässen Schaltungsanordnung.

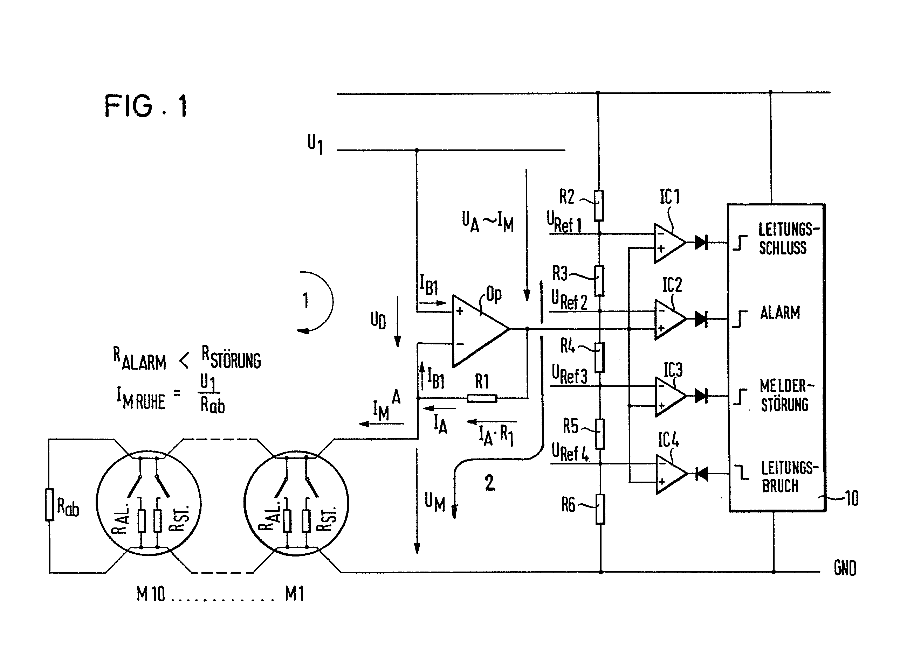

Gemäss der Darstellung in der Fig. 1 ist eine Brückenschaltung vorhanden, in deren einem Zweig ein Operationsverstärker Op und in Reihe dazu eine Parallelschaltung aus Alarmfühlern oder Alarmmeldern M1, ..., M10 mit einem parallel zu den Alarmfühlern angeordneten Meldelinien-Abschlusswiderstand Rab angeordnet sind. Der andere Brückenzweig wird durch Spannungsteiler-Widerstände R2 bis R6 gebildet. Der Operationsverstärker Op ist durch einen Widerstand R1 gegengekoppelt.

An die Abgriffe zwischen den Spannungsteiler-Widerständen R2 bis R6 sind die einzelnen Stufen IC1 bis IC4 eines Spannungskomparators angeschlossen. Über Dioden sind die Ausgänge der Spannungskomparator-Stufe an eine Steuerelektronik 10 angeschlossen, welche auch die Auswertung von Alarm-Signalen nach vorgegebenen Kriterien durchführt.

Von wesentlicher Bedeutung für die in der Fig. 1 dargestellte Schaltung ist der Operationsverstärker Op, der über den Widerstand R1 gegengekoppelt ist. Infolge der Gegenkopplung stellt sich das Potential des invertierenden Eingangs auf das Potential des nicht invertierenden Eingangs ein, nämlich auf $U_1$. Dadurch steht die volle Meldespannung $U_M = U_1$ zur Verfügung. Der Meldelinienstrom $I_M$ wird dabei vom Ausgang des Operationsverstärkers Op aufgebracht und erzeugt an dem Widerstand R1 einen entsprechenden Spannungsabfall $U_A = R_1 \cdot I_M$ (wie später gezeigt wird, gilt $I_M = I_A$), der am Ausgang als niederohmiger Spannungswert mit den Bezugsspannungswerten der Spannungskomparatoren verglichen wird und ausgewertet werden kann.

Die zum Verständnis der Arbeitsweise der oben beschriebenen Schaltung zweckmässigen Ströme und Spannungen sind mit entsprechenden Richtungspfeilen in der Fig. 1 an allen relevanten Stellen angegeben. Auf diese Kennzeichnungen wird hiermit ausdrücklich hingewiesen, und sie werden ausdrücklich zum Inhalt der vorliegenden Beschreibung erklärt.

Die Messung des Stromes ohne zusätzlichen Spannungsverlust wird nachfolgend dargelegt.

Es gelten folgende idealisierte Beziehungen:

$V_o$ = Leerlaufverstärkung des Operationsverstärkers,

$V_o = \infty$;

$Z_{EO}$ = Eingangswiderstand des Operationsverstärkers,

$Z_{EO} = \infty$;

$U_D$ = Differenz der Eingangsspannung zwischen invertierendem und nicht invertierendem Eingang,

$U_D = 0\,V$.

*Masche 1:* $\Sigma U = 0$:

$$U_D + U_M - U_1 = 0 \qquad (1)$$

mit $U_D = 0$ ergibt sich: $U_M = U_1$ $\qquad (2)$

*Masche 2:* $\Sigma U = 0$:

$$U_A + I_A \cdot R_1 + U_M - U_1 = 0 \qquad (3)$$

setzt man Gleichung 2 in Gleichung 3 ein, erhält man:

$$U_A = -I_A \cdot R_1 \qquad (4)$$

$$U_A \sim I_A\,(I_M) \qquad (5)$$

*Knoten A:* $\Sigma I = 0$:

$$I_A - I_M - I_{B1} = 0 \qquad (6)$$

mit $I_{B1} = 0$ ergibt sich: $I_A = I_M$ $\qquad (7)$

Aus den Gleichungen 2, 4 und 7 ist ersichtlich, dass einerseits die Meldelinienspannung immer gleich der Versorgungsspannung $U_1$ ist, unabhängig vom fliessenden Meldestrom, und andererseits die Ausgangsspannung $U_a$ dem Strom $I_M$ proportional ist. Somit steht ein zum Meldelinienstrom äquivalenter Spannungswert niederohmig zur Verfügung, der daher auf einfache Weise weiterverarbeitet werden kann.

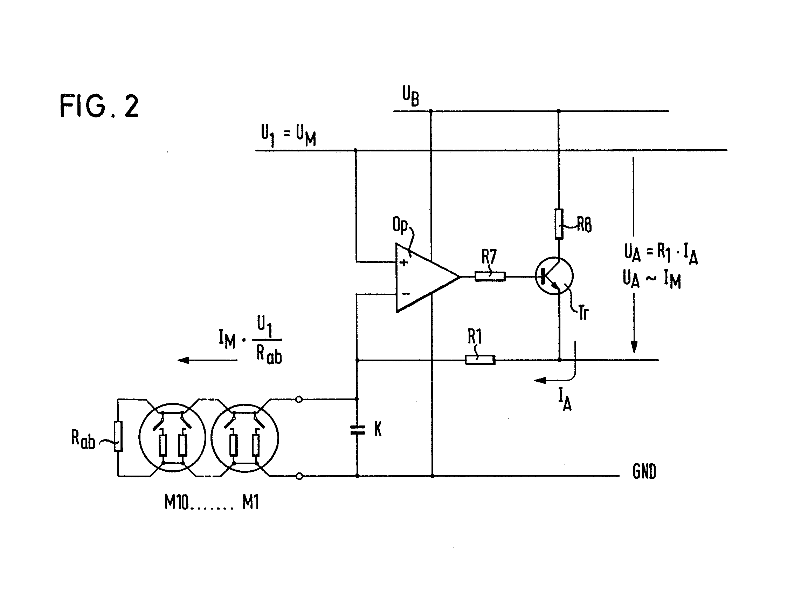

In der Fig. 2 ist das Grundprinzip einer bevorzugten Weiterentwicklung der erfindungsgemässen Schaltungsanordnung dargestellt.

Da der notwendige Meldelinienstrom $I_M$ vom Ausgang des Operationsverstärkers Op geliefert werden muss, ist es vorteilhaft, dem Operationsverstärker Op eine Leistungsstufe nachzuschalten.

Diese Leistungsstufe liefert ohne Schwierigkeit den notwendigen Meldelinienstrom. Damit die gesamte Anordnung möglichst ideale Eigenschaften eines gegengekoppelten Operationsverstärkers aufweist, wird die Leistungsstufe in die Gegenkopplung einbezogen. Die in der Fig. 2 dargestellte Schaltung verhält sich im Ergebnis analog zu der oben beschriebenen Arbeitsweise.

Die Leistungsstufe besteht im wesentlichen aus einem Transistor Tr, dessen Basis über einen Vorwiderstand R7 an den Ausgang des Operationsverstärkers Op angeschlossen ist. Der Emitter des Transistors Tr ist an den im Gegenkopplungszweig angeordneten Widerstand R1 angeschlossen. Der Kollektor des Transistors Tr ist über einen Widerstand R8 mit der Versorgungsspannungsquelle U_B verbunden. Parallel zu den Alarmfühlern oder Alarmmeldern M1 bis M10 ist ein Kondensator K angeordnet.

Im übrigen entspricht der Aufbau und zumindest im Ergebnis die Arbeitsweise der in der Fig. 2 dargestellten Schaltung.

## Patentansprüche

1. Schaltungsanordnung für eine Gefahrenmeldeanlage, insbesondere für eine Einbruch- oder Brandmeldeanlage, mit wenigstens einem in einer ruhestrommässig überwachten Meldelinie angeordneten Alarm-Fühler (M1, ..., M10), der beim Ansprechen im Alarm-Fall seinen Widerstand wesentlich verändert, wobei der Alarm-Fühler in Reihe mit einem Messwiderstandsglied einen Zweig einer Brückenschaltung bildet, deren anderer Zweig aus einer vorgebbaren Anzahl von Spannungsteiler-Widerständen (R2, ..., R6) gebildet ist, und wobei an die Brückenanordnung ein Spannungskomparator (IC1, ..., IC4) angeschlossen ist, dessen Ausgang mit einer Steuerstufe (10) verbunden ist, in welcher eine Auswertung eines die Brückenanordnung verstimmenden Alarmsignals nach vorgebbaren Kriterien erfolgt, dadurch gekennzeichnet, dass das Messwiderstandsglied aus einem gegengekoppelten Operationsverstärker (Op) gebildet ist und dass die Gegenkopplung derart dimensioniert ist, dass das Potential des invertierenden Eingangs des Operationsverstärkers (Op) praktisch dem Potential des nicht invertierenden Eingangs entspricht, so dass die Meldespannung (U_M) unabhängig vom fliessenden Meldestrom (I_M) konstant bleibt.

2. Schaltungsanordnung nach Anspruch 1, dadurch gekennzeichnet, dass dem Operationsverstärker (Op) eine Leistungsstufe (Tr, R7, R8) nachgeschaltet ist.

3. Schaltungsanordnung nach Anspruch 2, dadurch gekennzeichnet, dass die Leistungsstufe (Tr, R7, R8) im Gegenkopplungskreis angeordnet ist.

4. Schaltungsanordnung nach einem der Ansprüche 2 oder 3, dadurch gekennzeichnet, dass die Leistungsstufe einen Transistor (Tr) aufweist, dessen Basis über einen Vorwiderstand (R7) mit dem Ausgang des Operationsverstärkers (Op) verbunden ist, dessen Emitter mit dem Gegenkopplungswiderstand (R1) verbunden ist und dessen Kollektor über einen Widerstand (R8) mit der Versorgungsspannungsquelle (U_B) verbunden ist.

## Claims

1. Circuit arrangement for an alarm system, particularly for a burglar or fire alarm system, with at least one alarm sensor (M1, ..., M10) arranged in a closed-circuit current-monitored alarm line and which on responding in the case of an alarm significantly changes its resistance, the alarm sensor in series with a precision resistor element forming a branch of a bridge circuit, whose other branch is formed by a predeterminable number of voltage dividing resistors (R2, ..., R6), a voltage comparator (IC1, ..., IC4) being connected to the bridge circuit and its output is connected to a control stage (10), which evaluates in accordance with predeterminable criteria an alarm signal which detunes the bridge circuit, characterized in that the precision resistor element is formed by a negative feedback operational amplifier (Op) and that the negative feedback is dimensioned in such a way that the potential of the inverting input of the operational amplifier (Op) corresponds to the potential of the non-inverting input, so that the alarm voltage (U_M) remains constant, independently of the flowing alarm current (I_M).

2. Circuit arrangement according to Claim 1, characterized in that a power stage (Tr, R7, R8) is connected in series with the operational amplifier (Op).

3. Circuit arrangement according to Claim 2, characterized in that the power stage (Tr, R7, R8) is arranged in the feedback circuit.

4. Circuit arrangement according to one of the Claims 2 or 3, characterized in that the power stage has a transistor (Tr), whose base is connected across a series resistor (R7) to the output of the operational amplifier (Op), whose emitter is connected to the negative feedback resistor (R1) and whose collector is connected across a resistor (R8) to the supply voltage source (U_B).

## Revendications

1. Montage de circuit pour un système avertisseur de danger, en particulier pour un système avertisseur antivol ou anti-incendie, ayant au moins un détecteur d'alarme (M1, ..., M10) disposé sur une ligne d'alarme de veille à courant de repos faible, dont la résistance est sensiblement modifiée en réponse à une situation d'alarme, dans lequel le détecteur d'alarme forme une branche d'un circuit en pont en série avec un élément de résistance de mesure dont l'autre branche est constituée par un nombre variable de résistances-diviseurs de tension (R2, ..., R6) et dans lequel un comparateur de tension (IC1, ..., IC4) est raccordé à la disposition en pont, dont la sortie est reliée à un maître oscillateur (10), dans lequel une évaluation d'un signal d'alarme perturbant la disposition en pont s'effectue suivant des critères préétablis, caractérisé par le fait que l'élément de résistance de mesure est constitué d'un amplificateur opérationnel (Op) à contre-réaction et que la contre-réaction est dimensionnée de telle sorte que le potentiel de l'entrée d'inversion de l'amplificateur opérationnel (Op) correspond pratiquement au potentiel de l'entrée d'inversion, de sorte que la tension d'alarme ($U_M$) reste constante, indépendamment du courant d'alarme ($I_M$) qui passe.

2. Montage de circuit selon la revendication 1, caractérisé par le fait qu'un étage de puissance (Tr, R7, R8) est raccordé à la suite de l'amplificateur opérationnel (Op).

3. Montage de circuit selon la revendication 2, caractérisé par le fait que l'étage de puissance (Tr, R7, R8) est disposé en circuit à contre-réaction.

4. Montage de circuit selon l'une des revendications 2 ou 3, caractérisé par le fait que l'étage de puissance présente un tansistor (Tr) dont la base est reliée par l'intermédiaire d'une résistance série (R7) à la sortie de l'amplificateur opérationnel (Op), dont l'émetteur est relié à la résistance de contre-réaction (R1) et dont le collecteur est relié à la source de tension de distribution ($U_B$) par l'intermédiaire d'une résistance (R8).

FIG . 1

$U_A \sim I_M$

$R_{ALARM} < R_{STÖRUNG}$

$I_{MRUHE} = \dfrac{U_1}{R_{ab}}$

M 10 ............ M1

FIG. 2